# EUROPEAN PATENT APPLICATION

(11) **EP 2 426 729 A1**
(43) Date of publication of application: **07.03.2012**
(21) Application number: 10769698.1
(22) Date of filing: 26.04.2010
(51) Int. Cl.: H01L 31/042

(54) **SOLAR CELL MODULE AND BACK SHEET THEREFOR**

(30) Priority: 27.04.2009 JP 2009108292; 24.07.2009 JP 2009173449
(71) Applicant: Daikin Industries, Ltd., Osaka 530-8323 (JP)
(72) Inventor: NAGATO, Masaru, Settsu-shi Osaka 566-8585 (JP); IMOTO, Katsuhiko, Settsu-shi Osaka 566-8585 (JP); NAKAGAWA, Hideto, Settsu-shi Osaka 566-8585 (JP); AOKI, Kazuko, Settsu-shi Osaka 566-8585 (JP); GOBOH, Kenji, Settsu-shi Osaka 566-8585 (JP)
(74) Representative: Bachelin, Karl Martin Raimund
(86) International application number: PCT/JP2010/057355
(87) International publication number: WO 2010/126000

(57) **Abstract**

There is provided a back sheet of solar cell and a solar cell module where adhesion to a water-impermeable sheet is improved and adhesion to an ethylene/vinyl acetate copolymer is further improved. The back sheet of the solar cell module has, at least on either surface of a water-impermeable sheet, a cured coating film layer of a coating containing a hydroxyl-containing fluoropolymer and an isocyanate prepolymer and/or melamine resin as a curing agent.

## Description

### TECHNICAL FIELD

The present invention relates to a back sheet of solar cell module having excellent adhesion to a water-impermeable sheet included therein and further to an ethylene/vinyl acetate copolymer used as a sealant for solar cell module, and a solar cell module provided with the back sheet.

### BACKGROUND ART

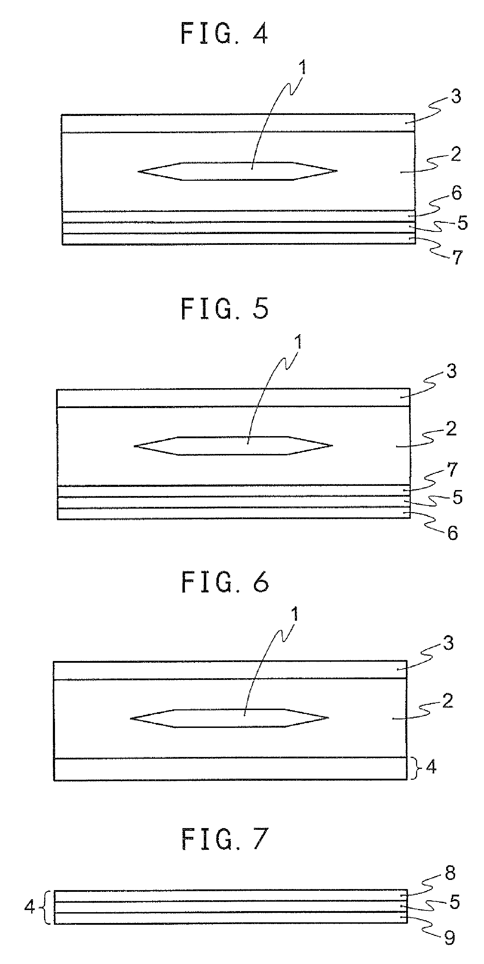

A solar cell module usually has a laminated structure such that as shown in Fig. 6, a solar cell 1 is sealed with a sealant layer 2, and the sealant layer 2 is sandwiched between a surface layer 3 comprising of glass or a clear resin or the like and a back sheet 4. An ethylene/vinyl acetate copolymer (EVA) is used as a sealant.

The back sheet 4 in the solar cell module has an aim of increasing mechanical strength of the module, and in addition, a function of preventing water (steam) from permeating the sealant layer 2.

As shown in Fig. 7, the back sheet 4 is comprised of a water-impermeable sheet 5 to provide water vapor barrier and a resin sheet 8 laminated on one surface of the water-impermeable sheet. Usually a resin sheet 9 is laminated on the other surface of the water-impermeable sheet 5 too.

Examples of materials of the water-impermeable sheet 5 are silica (Si)-deposited polyester (Si-deposited PET) having excellent water impermeability and metals such as aluminum and stainless steel, and the thickness of the sheet 5 is usually from 10 to 20 µm.

The resin sheets 8 and 9 are required to have characteristics such as weatherability, electrical insulation, flame resistance and designability, and a polyvinyl fluoride polymer (PVF) sheet is used therefor. In some cases, a polyethylene sheet is used as the resin sheet 8 at the side of the sealant layer 2.

However, the thickness of these resin sheets normally needs to be from 20 to 100 µm in order to satisfy required characteristics such as weatherability, electrical insulation and light-shielding property. Therefore further weight reduction has been demanded.

To satisfy such demand, there is proposed formation of a similar layer using a resin coating instead of a resin sheet (Patent Documents 1 and 2).

In Patent Document 1, an epoxy resin coating is used as a resin coating. However, an epoxy resin is insufficient in view of its weatherability, and has not been put into practical use.

In Patent Document 2, there is proposed a back sheet of two-layer structure produced by coating a metallic substrate (water-impermeable sheet) with a PVdF coating prepared by blending a specific amount of tetraalkoxysilane or a partially hydrolyzed product thereof to PVdF without functional groups. This PVdF coating is inferior in adhesion to EVA being a sealant when used alone because PVdF has no functional groups. In Patent Document 2, this point is improved by blending a specific amount of tetraalkoxysilane or a partially hydrolyzed product thereof, thus causing orientation of tetraalkoxysilane or a partially hydrolyzed product thereof toward an interface with EVA. However, since tetraalkoxysilane or a partially hydrolyzed product thereof exists locally around the interface with EVA, adhesion of a PVdF coating film to a metallic substrate is still not improved. Further, PVdF is a crystalline compound and has no functional groups, and in order to form a coating film, the coating must be subjected to the baking by heating at 200 to 300°C for 20 to 120 seconds. Therefore coating on water-impermeable sheets other than metals is difficult.

Consequently the inventors of the present invention studied fluorine-containing coating films and found out that a back sheet of solar cell having excellent adhesion to a water-impermeable sheet irrespective of kind of the water-impermeable sheet can be obtained, by forming a cured coating film layer of a coating containing a hydroxyl-containing fluoropolymer on at least one surface of the water-impermeable sheet (Patent Document 3).

### PRIOR ART DOCUMENTS

### PATENT DOCUMENTS

Patent Document 1: JP 7-176775 A
Patent Document 2: JP 2004-214342 A
Patent Document 3: JP 2007-035694 A

### DISCLOSURE OF INVENTION

### PROBLEM TO BE SOLVED BY THE INVENTION

The present invention aims to provide a back sheet of solar cell having further improved adhesion to a water-impermeable sheet as compared with that achieved in Patent Document 3, and further a solar cell module whose adhesion to EVA being a sealant is also improved.

With respect to other problems to be solved, explanation is made according to specific embodiments.

### MEANS TO SOLVE THE PROBLEM

Namely, the present invention relates to a back sheet of a solar cell module in which a cured coating film layer of a hydroxyl-containing fluoropolymer containing an isocyanate prepolymer and/or melamine resin as a curing agent is formed on at least one surface of the water-impermeable sheet.

The back sheet of the present invention may be a two-layer structure having, only on either surface of the water-impermeable sheet, a cured coating film layer of a coating containing a hydroxyl-containing fluoropolymer, a three-layer structure having, on both surfaces of the water-impermeable sheet, cured coating film layers of a coating containing a hydroxyl-containing fluoropolymer, or a three-layer structure having, on one surface of the water-impermeable sheet, a cured coating film layer of a coating containing a hydroxyl-containing fluoropolymer, and, on another surface thereof, a cured coating film layer of a coating containing a fluoropolymer having no curable functional groups, a fluoropolymer sheet, a polyester sheet or a coating film of a polyester coating (hereinafter may be referred to as "other sheet or coating film").

In addition, known one or two or more intermediate layers may exist between the water-impermeable sheet and the cured coating film layer and/or other sheet or coating film in order to improve the adhesion and their hiding properties and the water vapor permeability. Representative example of such intermediate layer is a primer layer.

Examples of the water-impermeable sheet which can be preferably used are known materials such as Si or silica (SiO₂)-deposited polyester sheets or metallic sheets.

In the case of forming a cured coating film layer of a coating containing a hydroxyl-containing fluoropolymer on the surface of the water-impermeable sheet at the side of a sealant (usually EVA) layer of a solar cell module, the functional group of the hydroxyl-containing fluoropolymer undergoes co-crosslinking with EVA, thereby further improves adhesion.

In addition, from the viewpoint of appearance of the solar cell module, it is preferable to disperse a pigment in the cured coating film layer of a coating containing a hydroxyl-containing fluoropolymer. From this point of view, a tetrafluoroethylene (TFE) hydroxyl-containing fluoropolymer with an excellent dispersibility of a pigment is preferable.

The present invention also relates to a solar cell module provided with the above-mentioned back sheet.

The present invention further relates to a solar cell module including a laminated structure where a sealant layer comprising an ethylene/vinyl acetate copolymer (EVA) and a cured coating film layer of a hydroxyl-containing fluoropolymer which comprises an isocyanate prepolymer and/or a melamine resin as a curing agent are directly laminated. The present invention also relates to a solar cell module including a laminated structure where a sealant layer comprising EVA and a water-impermeable sheet are laminated on a cured coating film layer of a hydroxyl-containing fluoropolymer which comprises an isocyanate prepolymer and/or a melamine resin as a curing agent.

### EFFECT OF THE INVENTION

According to the back sheet of the present invention, adhesion of a fluoropolymer layer to a water-impermeable sheet can be improved irrespective of kind of a water-impermeable sheet. Moreover, adhesion to EVA being a sealant is further enhanced.

The back sheet of the present invention can be formed by using a coating, and therefore, the thickness thereof can be made thinner as compared with a conventional back sheet produced by laminating a sheet, thus making it possible to make the back sheet thinner and lighter. In addition, lowering of the mechanical strength due to a decrease in thickness of a coating film can be compensated for by curing (crosslinking) a curable functional group.

Also, for example, adhesion to the water-impermeable sheet can be improved by introducing the functional groups to the fluoropolymer.

Other effects of the present invention are explained herein by means of specific embodiments.

### BRIEF DESCRIPTION OF DRAWINGS

Fig. 1 is a diagrammatic cross-sectional view of the first embodiment of the solar cell module of the present invention.
Fig. 2 is a diagrammatic cross-sectional view of the second embodiment of the solar cell module of the present invention.
Fig. 3 is a diagrammatic cross-sectional view of the third embodiment of the solar cell module of the present invention.
Fig. 4 is a diagrammatic cross-sectional view of the fourth embodiment of the solar cell module of the present invention.
Fig. 5 is a diagrammatic cross-sectional view of the fifth embodiment of the solar cell module of the present invention.
Fig. 6 is a diagrammatic cross-sectional view of a conventional solar cell module.
Fig. 7 is a diagrammatic cross-sectional view of a back sheet of a conventional solar cell module.

### BEST MODE FOR CARRYING OUT THE INVENTION

The feature of the back sheet of the present invention is that a cured coating film layer of a coating containing a hydroxyl-containing fluoropolymer comprising a specific curing agent is used as a polymer layer to be provided for imparting weatherability, hiding property, chemical resistance, moisture proof and salt resistance.

A coating composition containing a hydroxyl-containing fluoropolymer as a film forming component and an isocyanate prepolymer and/or a melamine resin as a curing agent is used as the coating containing a hydroxyl-containing fluoropolymer which is used to form such cured coating film layer.

Examples of the hydroxyl-containing fluoropolymer are polymers obtained by introducing hydroxyl to fluoropolymers. The fluoropolymer includes resinous polymers having a definite melting point, elastomeric polymers exhibiting rubber elasticity and thermoplastic elastomeric polymers which have intermediate property between these two polymers.

Hydroxyl group is usually introduced to the fluoropolymer by copolymerization of a hydroxyl-containing monomer.

Examples of a hydroxyl-containing monomer are the followings while not limited thereto.

Examples of a hydroxyl-containing monomer are, for instance, hydroxyl-containing vinyl ethers such as 2-hydroxyethyl vinyl ether, 3-hydroxypropyl vinyl ether, 2-hydroxypropyl vinyl ether, 2-hydroxy-2-methylpropyl vinyl ether, 4-hydroxybutyl vinyl ether, 4-hydroxy-2-methylbutyl vinyl ether, 5-hydroxypentyl vinyl ether and 6-hydroxyhexyl vinyl ether; hydroxyl-containing allyl ethers such as 2-hydroxyethyl allyl ether, 4-hydroxybutyl allyl ether and glycerol monoallyl ether; and the like. Among these, hydroxyl-containing vinyl ethers, especially 4-hydroxybutyl vinyl ether and 2-hydroxyethyl vinyl ether are preferable from the viewpoint of satisfactory polymerization reactivity and curability of functional groups.

Examples of other hydroxyl-containing monomers are, for instance, hydroxyalkyl esters of (meth)acrylic acids such as 2-hydroxyethyl acrylate and 2-hydroxyethyl methacrylate.

Examples of fluoropolymers to which a hydroxyl group is introduced are, for instance, those mentioned below from the viewpoint of constitutional units.

### (1) Perfluoroolefin polymers comprising a perfluoroolefin unit as a main component:

Specific examples are a tetrafluoroethylene (TFE) homopolymer, copolymers of TFE with hexafluoropropylene (HFP) and perfluoro(alkyl vinyl ether) (PAVE) or the like, and in addition, copolymers of these with other copolymerizable monomers.

Nonlimiting examples of other copolymerizable monomers are, for instance, vinyl esters of carboxylic acid such as vinyl acetate, vinyl propionate, vinyl butyrate, vinyl isobutyrate, vinyl pivalate, vinyl caproate, vinyl versatate, vinyl laurate, vinyl stearate, vinyl cyclohexyl carboxylate, vinyl benzoate and vinyl para-t-butyl benzoate; alkyl vinyl ethers such as methyl vinyl ether, ethyl vinyl ether, butyl vinyl ether and cyclohexyl vinyl ether; non-fluorine-containing olefins such as ethylene, propylene, n-butene and isobutene; and fluorine-containing monomers such as vinylidene fluoride (VdF), chlorotrifluoroethylene (CTFE), vinyl fluoride (VF) and fluorinated vinyl ether.

Among these, TFE polymers comprising TFE as a main component are preferable from the viewpoint that they are excellent in dispersibility of a pigment, weatherability, copolymerizability and chemical resistance.

Specific examples of hydroxyl-containing perfluoroolefin polymers are a copolymer of TFE, isobutylene, hydroxybutyl vinyl ether and other monomers, a copolymer of TFE, vinyl versatate, hydroxybutyl vinyl ether and other monomers, a copolymer of TFE, VdF, hydroxybutyl vinyl ether and other monomers, and the like, and especially a copolymer of TFE, isobutylene, hydroxybutyl vinyl ether and other monomers and a copolymer of TFE, vinyl versatate, hydroxybutyl vinyl ether and other monomers are preferable.

Examples of curable TFE polymer coating are ZEFFLE GK series available from DAIKIN INDUSTRIES, LTD. and the like.

### (2) CTFE polymers comprising a chlorotrifluoroethylene (CTFE) unit as a main component:

Specific examples are, for instance copolymers of CTFE, hydroxybutyl vinyl ether and other monomers and the like.

Examples of a curable CTFE polymer coating are, for instance, LUMIFLON available from Asahi Glass Co., Ltd., FLUONATE available from DAINIPPON INK AND CHEMICALS INCORPORATED, CEFRAL COAT available from Central Glass Co., Ltd., ZAFLON available from TOAGOSEI CO., LTD. and the like.

### (3) VdF polymers comprising a vinylidene fluoride (VdF) unit as a main component:

Specific examples are, for instance copolymers of VdF, TFE, hydroxybutyl vinyl ether and other monomers and the like.

### (4) Fluoroalkyl group-containing polymers comprising a fluoroalkyl unit as a main component:

Specific examples are, for instance, copolymers of CF₃CF₂(CF₂CF₂)ₙCH₂CH₂OCOCH=CH₂ (a mixture of n=3 and n=4), 2-hydroxyethyl methacrylate and stearyl acrylate and the like.

Examples of fluoroalkyl group-containing polymers are, for instance, UNIDYNE and Ftone available from DAIKIN INDUSTRIES, LTD., Zonyl available from Du Pont and the like.

Among these, perfluoroolefin polymers are preferable in consideration of weatherability and moisture proof.

Coating compositions comprising, as a coating film forming component, these hydroxyl-containing fluoropolymers can be prepared by a usual method in the form of a solvent coating composition, an aqueous coating composition and a powder coating composition. Among these, especially a solvent coating composition is preferable from the viewpoint of easy film formation, curability and drying characteristic.

The present invention is characterized by using an isocyanate prepolymer or a melamine resin or the both of them as a curing agent for coating compositions comprising, as a coating film forming component, these hydroxyl-containing fluoropolymers.

An example of isocyanate prepolymer is a modified polyisocyanate and examples thereof are a reaction product of polyisocyanate with a polyhydroxy compound, a reaction product of polyisocyanate with a polyamine compound and the like.

Examples of polyisocyanate are aliphatic polyisocyanates such as butane diisocyanate, pentane diisocyanate, hexamethylene diisocyanate (HDI) and triisocyanatononan: alicyclic polyisocyanates such as cyclohexyl isocyanate and isophorone diisocyanate (IPDI): and aromatic polyisocyanates such as tolylene diisocyanate (TDI), 4,4'-diphenylmethane diisocyanate (MDI) and xylylene diisocyanate (XDI). Among these, aliphatic polyisocyanates and alicyclic polyisocyanates are preferable from the viewpoint of weatherability.

Examples of a polyhydroxy compound are low molecular weight diols such as 1,2-ethanediol, 1,3-propanediol, 1,2-propanediol and 1,4-butanediol: triols such as glycerol and trimethylol propane: tetraols such as pentaerythritol: polyether polyol, polyester polyol, polycarbonate polyol, polythioether polyol and the like.

Examples of a polyamine compound are low molecular weight diamines such as 1,2-ethanediamine, 1,3-propanediamine, 1,2-propanediamine and 1,4-butanediamine: tetraamines such as 1,2,5-pentanetriamine: tetraamines such as 1,2,4,5-benzenetetraamine and the like.

Specifically, a modified polyisocyanate (Desmodule N3800 available from Sumika Bayer Urethane Co., Ltd.) obtained by modifying hexamethylene diisocyanate (HDI), a modified polyisocyanate (TSE100 available from AsahiKasei Chemicals Corporation) obtained by modifying hexamethylene diisocyanate (HDI) and a modified polyisocyanate (Takenate D-140N available from Mitsui Chemicals, Inc.) obtained by modifying isophorone diisocyanate (IPDI) can be used. These modified polyisocyanates are distinguished from isocyanate curing agents being hexamethylene diisocyanate (HDI) such as CORONATE HX available from Nippon Polyurethane Industry Co., Ltd.

Isocyanate prepolymers may be used alone or in combination of two or more thereof.

Preferable examples of a melamine resin are esterified compounds prepared by reaction of a methylol melamine derivative obtained by condensation of melamine and formaldehyde with lower alcohol such as methyl alcohol, ethyl alcohol, isopropyl alcohol, butyl alcohol, isobutyl alcohol or the like, and mixtures thereof.

Examples of methylol melamine derivatives are monomethylol melamine, dimethylol melamine, trimethylol melamine, tetramethylol melamine, pentamethylol melamine, hexamethylol melamine and the like.

Melamine resins are classified into a complete alkyl type, a methylol type, an imino type and a methylol/ imino type according to a proportion of alkoxylated melamine, and all types of melamine resins can be used in the present invention.

In addition, various additives can be blended to the coating composition containing a hydroxyl-containing fluoropolymer according to required characteristics. Examples of additives are a curing accelerator, a pigment dispersing agent, a defoaming agent, a leveling agent, a UV absorbent, a photo-stabilizer, a thickener, an adhesion improving agent and a flatting agent.

Known tin-based, other metal-based, organic acid-based curing accelerators and amine based curing accelerators can be used as a curing accelerator.

It is strongly desired to add a pigment from the viewpoint of making appearance of a solar cell module beautiful and protecting a water-impermeable sheet from ultraviolet light. Especially white pigments such as titanium oxide and calcium carbonate, black pigments such as carbon black, and composite metals such as Cu-Cr-Mn alloy and the like are usually blended.

The water-impermeable sheet is a layer provided in order to prevent permeation of water into the sealant EVA and the solar cell, and any materials can be used as far as water substantially does not permeate through them. In many cases, from the viewpoint of weight, price and flexibility, a polyester resin sheet of polyethylene terephthalate (PET), polyethylene naphthalate or the like: a polyolefin resin sheet of polyethylene, polypropylene or the like: a polyurethane resin sheet, a polycarbonate resin sheet, a polyamide resin sheet, a polystyrene resin sheet, a polyacrylonitrile resin sheet, a polyvinyl chloride resin sheet, a polyvinyl acetal resin sheet, a polyvinyl butyral resin sheet, a fluorine-containing resin sheet are used. In addition, Si or Al-deposited products of the above resin sheets such as a silica-deposited PET sheet and an aluminum- or alumina-deposited PET sheet, a metallic foil sheet of aluminum or stainless steel and a metal oxide foil sheet of alumina or the like are also used. Among these, especially silica-deposited PET sheet is often used. The thickness of the sheet is usually about 10 to 20 µm.

Also, in order to improve adhesion, the water-impermeable sheet may be subjected to known surface treatment. Examples of the surface treatment are, for instance, corona discharge treatment, plasma discharge treatment and chemical conversion treatment, and in the case of metallic sheet, blasting treatment or the like can be exemplified.

A cured coating film layer is formed on the water-impermeable sheet by coating a coating composition containing, as a coating film forming component, a hydroxyl-containing fluoropolymer on the water-impermeable sheet according to a form of coating.

The coating procedures may be carried out within usual temperature condition for a form of coating composition. In the case of a solvent coating composition, curing of the coating film is carried out at a temperature of from 10 to 300°C, usually at normal temperature (20 to 30°C). Therefore materials for which high temperature treatment should be avoided, for example, a Si-deposited PET sheet such as a silica-deposited PET sheet can be used as a water-impermeable sheet without any problem. The curing is usually completed at 20 to 300°C in one minute to three days.

The coating may be carried out directly on the water-impermeable sheet or on a primer layer or the like.

The primer layer is formed by usual method using a known coating for primer. Representative examples of a coating for primer are, for instance, an epoxy resin, a urethane resin, an acrylic resin, a silicone resin and a polyester resin.

The thickness of the cured coating film layer is preferably not less than 5 µm, further preferably not less than 10 µm, especially preferably not less than 15 µm, from the viewpoint of satisfactory hiding property, weatherability, chemical resistance and moisture proof. An upper limit of the thickness is preferably about 1,000 µm, further preferably 100 µm because if the film is too thick, an effect of making its weight smaller cannot be obtained. The thickness is especially preferably from 15 to 40 µm.

Hereinafter, the solar cell module of the present invention will be explained.

The solar cell module of the present invention comprises a laminated structure in which a sealant layer containing EVA and a cured coating film layer of a coating containing a hydroxyl-containing fluoropolymer and an isocyanate prepolymer and/or a melamine resin as a curing agent are directly laminated or a laminated structure in which a sealant layer comprising EVA and a water-impermeable sheet are laminated on a cured coating film layer of a coating containing a hydroxyl-containing fluoropolymer and an isocyanate prepolymer and / or melamine resin as a curing agent.

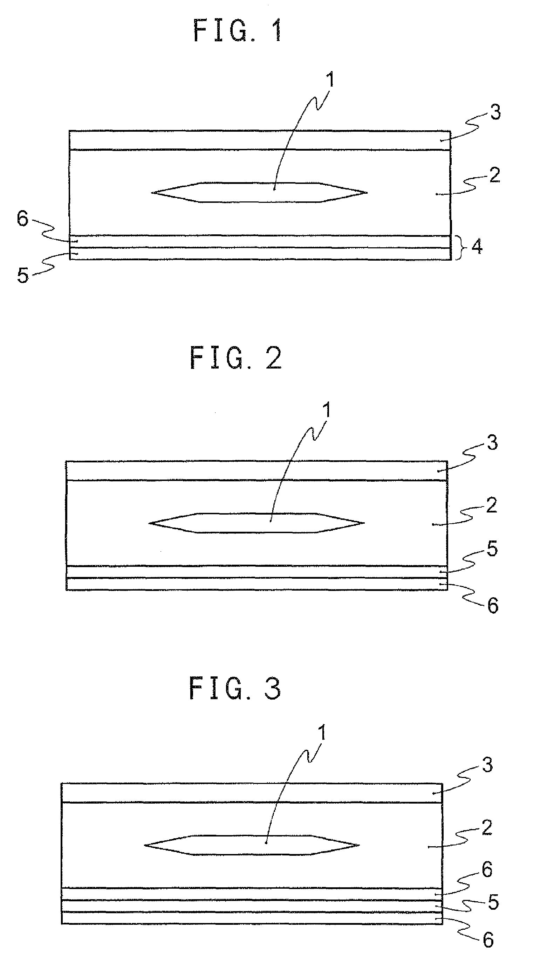

The solar cell module of the present invention is then explained by means of Fig. 1 showing a preferable embodiment. Other preferable embodiments of the present invention are shown in Figs. 2 to 5.

In Fig. 1, numeral 1 represents a solar cell which is sealed with a sealant layer 2 as represented by EVA, and the sealant layer 2 is sandwiched between the surface layer 3 and the back sheet 4. The back sheet 4 is further comprised of the water-impermeable sheet 5 and the cured coating film layer 6 of a coating containing a hydroxyl-containing fluoropolymer. In this first embodiment, the cured coating film layer 6 is provided on the side of the sealing (EVA) layer 2.

In this embodiment, since the cured coating film layer 6 contacts EVA, interfacial adhesion between them is improved especially by co-crosslinking with EVA.

Fig. 2 shows the second embodiment and the cured coating film layer 6 is provided on the opposite side of the sealing (EVA) layer 2. In this embodiment, satisfactory weatherability is exhibited by providing the cured coating film layer 6. In addition, it is preferable from the viewpoint of improvement of adhesion that the water-impermeable sheet 5 is subjected to surface treatment at the side of the sealing (EVA) layer 2. Also, according to necessity, a polyester adhesive, an acryl adhesive, a urethane adhesive or an epoxy adhesive may be used.

The back sheet of the present invention may be a two-layer structure (Figs. 1 and 2) comprising the above-mentioned water-impermeable sheet 5 and the cured coating film layer 6 provided only on one surface of the water-impermeable sheet 5, or a three-layer structure explained below.

The embodiment (the third embodiment) of the back sheet of three-layer structure is shown in Fig. 3. The third embodiment is a three-layer structure comprising the water-impermeable sheet 5 and the cured coating film layers 6 of a coating containing a hydroxyl-containing fluoropolymer which are formed on both surfaces of the water-impermeable sheet 5.

The third embodiment has advantages of both of the first embodiment and the second embodiment though there is a problem from the viewpoint of the thickness of the back sheet.

The back sheet of three-layer structure may be the one comprising a cured coating film layer of a coating containing a hydroxyl-containing fluoropolymer formed on one surface of the water-impermeable sheet, and a cured coating film layer of a coating containing a fluoropolymer having no curable functional groups, a fluoropolymer sheet, a polyester sheet or a coating film of polyester coating (other sheet or coating film) formed on another surface of the water-impermeable sheet (Fig. 4 and Fig. 5).

The fourth embodiment (Fig. 4) shows a structure having the other coating film 7 formed on the opposite side of the sealing (EVA) layer 2 in the first embodiment, and the fifth embodiment (Fig. 5) shows a structure having the other coating film 7 formed on the side of the sealing (EVA) layer 2 in the second embodiment.

In either of the fourth and fifth embodiments, a material forming the layer 7 may include a cured coating film layer of a coating containing a fluoropolymer having no curable functional groups, a fluoropolymer sheet, a polyester sheet or a coating film of polyester coating.

Examples of the cured coating film layer of a coating containing a fluoropolymer having no curable functional groups are a cured coating film layer of a coating prepared by blending tetraalkoxysilane or a partially hydrolyzed product thereof to PVdF as described in Patent Document 2, a cured coating film layer of a coating mixture comprising a VdF/TFE/CTFE copolymer and an acrylic resin having an alkoxysilane unit, a cured coating film layer of a coating mixture comprising a VdF/TFE/HFP copolymer and a hydroxyl-containing acrylic resin, and a cured coating film layer of a coating prepared by blending an amino silane coupling agent to a VdF/HFP copolymer. It is preferable that the thickness of the film is usually from 5 to 300 µm, further from 10 to 100 µm, especially from 10 to 50 µm, from the viewpoint of satisfactory hiding property, weatherability, chemical resistance and moisture proof. In this case, the coating film may also be formed on a primer layer.

Examples of the fluoropolymer sheet are those used on usual back sheets, such as a PVdF sheet, a PVF sheet, a PCTFE sheet, a TFE/HFP/ethylene copolymer sheet, a TFE/HFP copolymer (FEP) sheet, a TFE/PAVE copolymer (PFA) sheet, an ethylene/TFE copolymer (ETFE) sheet, and an ethylene/CTFE copolymer (ECTFE) sheet. It is preferable that the thickness of the sheet is usually from 5 to 300 µm, further from 10 to 100 µm, especially from 10 to 50 µm, from the viewpoint of satisfactory weatherability.

With respect to the polyester sheet, those used on conventional back sheets can be used as they are. Adhesion of the polyester sheet to the water-impermeable sheet 5 can be carried out using for example, an acryl adhesive, a urethane adhesive, an epoxy adhesive or a polyester adhesive. It is preferable that the thickness of the sheet is usually from 5 to 300 µm, further from 10 to 100 µm, especially from 10 to 50 µm, from the viewpoint of satisfactory weatherability, cost and transparency.

Examples of the polyester coating are those prepared using a saturated polyester resin prepared from polycarboxylic acid and polyalcohol or the like, and those prepared using an unsaturated polyester resin prepared from glycols such as maleic anhydride or fumaric acid. The coating film thereof can be formed by a coating method such as roll coating, curtain coating, spray coating or die coating. It is preferable that the thickness of the film is usually from 5 to 300 µm, further from 10 to 100 µm, especially from 10 to 50 µm, from the viewpoint of satisfactory hiding property, weatherability, chemical resistance and moisture proof. Also in this case, the layer may be formed using a primer layer.

### EXAMPLE

The present invention is then explained by means of Preparation Examples and Examples while not limited thereto.

### PREPARATION EXAMPLE 1

223.2 Parts by mass of a hydroxyl-containing TFE copolymer (ZEFFLE GK570 available from DAIKIN INDUSTRIES, LTD., solid content: 65 % by mass, hydroxyl value: 60 mgKOH/g, solvent: butyl acetate), 250 parts by mass of a black pigment (DAIPYROXIDE 9510 available from Dainichiseika Color & Chemicals Mfg. Co., Ltd.) and 126.8 parts by mass of butyl acetate were preliminarily mixed by stirring, and thereto was added 780 parts by mass of glass beads having a diameter of 1.2 mm, followed by dispersing the mixture at 1,500 rpm for one hour with a pigment disperser. Then, the glass beads were filtrated with #80 mesh filter, and to the resultant solution were added 269.2 parts by mass of a hydroxyl-containing TFE copolymer (ZEFFLE GK570) and 80.7 parts by mass of butyl acetate to prepare a black coating.

To 100 parts by mass of this black coating were added 13 parts by mass of an isocyanate prepolymer curing agent (Desmodule N3800 available from Sumika Bayer Urethane Co., Ltd.) and 100 parts by mass of butyl acetate as a diluting solvent, to prepare a curable coating 1.

### PREPARATION EXAMPLE 2

223.2 Parts by mass of a hydroxyl-containing TFE copolymer (ZEFFLE GK570), 250 parts by mass of a black pigment (DAIPYROXIDE 9510) and 126.8 parts by mass of butyl acetate were preliminarily mixed by stirring, and thereto was added 780 parts by mass of glass beads having a diameter of 1.2 mm, followed by dispersing at 1,500 rpm for one hour with a pigment disperser. Then, the glass beads were filtrated with #80 mesh filter, and to the resultant solution were added 269.2 parts by mass of a hydroxyl-containing TFE copolymer (ZEFFLE GK570) and 80.7 parts by mass of butyl acrylate to prepare a black coating.

To 100 parts by mass of this black coating were added 13 parts by mass of an isocyanate prepolymer curing agent (Desmodule N3800), 3 parts by mass of a silane coupling agent (OCN-C₃H₆-Si(OCH₃)₃) and 100 parts by mass of butyl acetate as a diluting solvent, to prepare a curable coating 2.

### PREPARATION EXAMPLE 3

223.2 Parts by mass of a hydroxyl-containing TFE copolymer (ZEFFLE GK570), 250 parts by mass of titanium oxide (D918 available from Sakai Chemical Industry Co., Ltd.) as a white pigment and 126.8 parts by mass of butyl acetate were preliminarily mixed by stirring, and thereto was added 780 parts by mass of glass beads having a diameter of 1.2 mm, followed by dispersing at 1,500 rpm for one hour with a pigment disperser. Then, the glass beads were filtrated with #80 mesh filter, and to the resultant solution were added 269.2 parts by mass of a hydroxyl-containing TFE copolymer (ZEFFLE GK570) and 80.7 parts by mass of butyl acrylate to prepare a white coating.

To 100 parts by mass of this white coating were added 12 parts by mass of an isocyanate prepolymer curing agent (TSE100 available from AsahiKasei Chemicals Corporation) and 100 parts by mass of butyl acetate as a diluting solvent, to prepare a curable coating 3.

### PREPARATION EXAMPLE 4

223.2 Parts by mass of a hydroxyl-containing TFE copolymer (ZEFFLE GK570), 250 parts by mass of titanium oxide (TIPURE R960 available from Du Pont) as a white pigment and 126.8 parts by mass of butyl acetate were preliminarily mixed by stirring, and thereto was added 780 parts by mass of glass beads having a diameter of 1.2 mm, followed by dispersing at 1,500 rpm for one hour with a pigment disperser. Then, the glass beads were filtrated with #80 mesh filter, and to the resultant solution were added 269.2 parts by mass of a hydroxyl-containing TFE copolymer (ZEFFLE GK570) and 80.7 parts by mass of butyl acrylate to prepare a white coating.

To 100 parts by mass of this white coating were added 14 parts by mass of a melamine resin curing agent (Cymel 303 available from Mitsui Cytec Ltd.), 0.3 part by mass of aromatic sulfonic acid (Catalyst 602 available from Mitsui Cytec Ltd.) as a curing catalyst and 100 parts by mass of butyl acetate as a diluting solvent, to prepare a curable coating 4.

### PREPARATION EXAMPLE 5

100 Parts by mass of a hydroxyl-containing TFE copolymer (ZEFFLE GK570), 100 parts by mass of butyl acetate and 1.3 parts by mass each of UV absorbents (Tinuvin 400 and 473 available from Ciba Specialty Chemicals Inc.) were mixed by stirring to prepare a clear coating.

To 100 parts by mass of this clear coating were added 27 parts by mass of an isocyanate prepolymer curing agent (Desmodule N3800) and 100 parts by mass of butyl acetate as a diluting solvent, to prepare a curable coating 5.

### PREPARATION EXAMPLE 6

Curable coating 6 for comparison was prepared in the same manner as in Preparation Example 1 except that CORONATE HX available from NIPPON POLYURETHANE INDUSTRY CO., LTD., which is an isocyanate curing agent having a low molecular weight, was used as a curing agent.

### PREPARATION EXAMPLE 7

To 100 parts by mass of the black coating prepared in Preparation Example 1 were added 6.7 parts by mass of Desmodule N3800 as an isocyanate prepolymer curing agent and 7.0 parts by mass of Takenate D-140N (available from Mitsui Chemicals, Inc.), to prepare a curable coating 7.

### EXAMPLE 1

A silica-deposited PET film (BARRIERTECH H available from Mitsubishi Plastics, Inc., thickness: 12 µm, Sheet A) was used as a water-impermeable sheet, and the curable coating 1 prepared in Preparation Example 1 was coated on one surface of this Sheet A by air spray so as to give a dried coating film thickness of 20 µm, followed by drying at 180°C for two minutes, to produce a back sheet A1 of two-layer structure.

Adhesion 1 (between the coating film and the sheet) and bending characteristic were evaluated using this back sheet A1. The results are shown in Table 1.

Then an EVA resin sheet (SOLAR EVA available from Mitsui Chemicals Fabro, Inc., thickness: 400 µm) was placed on the coated film surface of the back sheet A and a glass plate was placed thereon, followed by the compression at 150°C at a pressure of 0.7 MPa, to produce a sample A1 (embodiment shown in Fig. 1) composed of EVA/ cured coating film (black) /sheet A. Adhesion 2 (between the EVA and the coating film) of this EVA-adhered sample A1 was evaluated. The results are shown in Table 1.

Testing methods and measuring methods are as follows.

### (Adhesion 1) Adhesion with a water-impermeable sheet

One-time test: Adhesion is evaluated by carrying out a cross-cut test (cross-cut to 1 mm width) according to JIS K6900 one time. Three-time test: Adhesion is evaluated by carrying out an adhesion test due to a cross-cut test (cross-cut to 1 mm width) according to JIS K6900 three times per each test part.

### (Adhesion 2) Adhesion with a sealant layer (EVA)

According to JIS K 6854-2, notches are made in the back sheet part of the EVA-adhered sample with a cutter knife to make a strip form with a width of 25 mm, to examine adhesion (peeling strength) between the EVA and the coating film surface. Autograph Universal Testing Machine available from SHIMADZU CORPORATION is used as a test instrument and a test is conducted at an atmosphere temperature of 23°C at a grip movement speed of 200 mm/min.

### (Bending characteristic)

The back sheet is cut into a 50 mm x 50 mm test piece. The test piece is wound on a 2 mm diameter round bar so that the coated film surface faces outward, and is bent 180 degrees (in one second), and whether or not cracking is found on the bent portion is observed with naked eyes. When cracking is found, two sheets of test pieces are overlapped and then bent 180 degrees in the same manner as above. This is repeated by increasing the number of sheets until cracking is not found, and the number of test pieces is recorded. When the number of test pieces is smaller, bending characteristic is better.

### (Thickness of a film)

A thickness is measured with an electromagnetic thickness meter.

### (Anti-blocking property)

The back sheet is cut into a 50 mm x 10 mm test piece. The test pieces are laminated so that the coated surface of the test piece contacts the substrate thereof and then sandwiched with hard glass plates having a thickness of 10 mm. A plumb of 25 kg is placed thereon so as to adjust an applied pressure to 5 N/cm². After retaining this condition for 12 hours under an atmosphere of 40°C, the test pieces are allowed to cool and released from pressure and the test pieces are separated from each other to evaluate ease of peeling thereof.

### Criteria for evaluation

○: The test pieces do not adhere to each other and peel off naturally.
△: Though the test pieces adhere to each other, the coated film does not rip when peeled.
× : The test pieces firmly adhere to each other and the coated film rips when peeled.

### COMPARATIVE EXAMPLE 1

The back sheet A2 of two-layer structure and the EVA-adhered sample A2 composed of EVA/cured coating film for comparison (black)/sheet A were prepared in the same manner as in Example 1 except that the curable coating 6 for comparison prepared in Preparation Example 6 was used as a coating. Adhesion and bending characteristics were examined in the same manner as in Example 1 and the results are shown in Table 1.

**TABLE 1**

| Structure of back sheet (Fig. 1) | Ex. 1 | Com. Ex. 1 |
|---|---|---|
| Coating film Water-impermeable sheet | Curable coating 1 Sheet A | Curable coating 6 Sheet A |
| Characteristics of back sheet | | |
| Adhesion 1 (one-time) | 100/100 | 100/100 |
| Adhesion 1 (three-time) | 100/100 | 98/100 |
| Bending characteristics (number of test pieces) | 1 | 1 |
| EVA laminate (sample) | | |
| EVA laminate surface | Coated film side | Coated film side |
| Adhesion 2 | | |
| Peeling strength (N/cm) | 26 | 21 |

From Table 1, it can be seen that in Example 1, not only adhesion to PET but also adhesion to the water-impermeable sheet and EVA is further improved.

### EXAMPLE 2

An EVA resin sheet was placed on the sheet A side of the back sheet A1 of two-layer structure, which was prepared in the same manner as in Example 1, by use of a polyester adhesive (AD-76P1 and CAT-10L (curing agent) available from Toyo-Morton, Ltd.). Then a glass plate was further placed thereon, followed by the compression at 150°C at a pressure of 100 g/cm², to produce a sample B1 (embodiment shown in Fig. 2) composed of EVA/adhesive/sheet A/cured coating film (black). Adhesion 2 (between the EVA and the coating film) and bending characteristic were evaluated using this EVA-adhered sample B1. The results are shown in Table 2.

### EXAMPLE 3

The silica-deposited PET film (sheet A) was used as a water-impermeable sheet, and the curable coating 4 prepared in Preparation Example 4 was coated on one surface of this sheet A by air spray so as to give a dried coating film thickness of 20 µm, followed by drying at 180°C for ten minutes, to produce a back sheet B2 of two-layer structure.

Adhesion 1 (between the coating film and the sheet) and bending characteristic were evaluated using this back sheet B2. The results are shown in Table 2.

Subsequently an EVA resin sheet was placed on the sheet A side of this back sheet B2 by use of a polyester adhesive (AD-76P1 and CAT-10L (curing agent) available from Toyo-Morton, Ltd.). Then a glass plate was further placed thereon, followed by the compression at 150°C at a pressure of 0.7 MPa, to produce a sample B2 (embodiment shown in Fig. 2) composed of EVA/adhesive/sheet A/cured coating film (white). Adhesion 2 (between the EVA and the coating film) was evaluated using this EVA-adhered sample B2. The results are shown in Table 2.

**TABLE 2**

| Structure of back sheet (Fig. 2) | Ex. 2 | Ex. 3 |
|---|---|---|
| Coating film | Curable coating 1 | Curable coating 4 |
| Water-impermeable sheet | Sheet A | Sheet A |
| Characteristics of back sheet | | |
| Adhesion 1 (one-time) | 100/100 | 100/100 |
| Adhesion 1 (three-time) | 100/100 | 100/100 |
| Bending characteristics (number of test pieces) | 1 | 1 |
| EVA laminate (sample) | | |
| EVA laminate surface | Sheet A side | Sheet A side |
| Adhesion 2 | | |
| Peeling strength (N/cm) | 28 | 29 |

From Table 2, it can be seen that the improvement effect of adhesion can be also obtained when a melamine resin is used as a curing agent.

### EXAMPLE 4

The silica-deposited PET film (sheet A) was used as a water-impermeable sheet, and the curable coating 1 prepared in Preparation Example 1 was coated on the both surfaces of this sheet A by air spray so as to give a dried coating film thickness of 20 µm in each surface, followed by drying at 180°C for two minutes, to produce a back sheet C1 of three-layer structure.

Adhesion 1 (between the coating film and the sheet) and bending characteristics were evaluated using this back sheet C1. The results are shown in Table 3.

Subsequently an EVA resin sheet was placed on one of the coated films of this back sheet C 1 and a glass plate was further placed thereon, followed by the compression at 150°C at a pressure of 0.7 MPa, to produce a sample C1 (embodiment shown in Fig. 3) composed of EVA/cured coating film (black)/sheet A/cured coating film (black). Adhesion 2 (between the EVA and the coating film) and weatherability were evaluated using this EVA-adhered sample C1. The results are shown in Table 3.

### (Weatherability test)

An accelerated weatherability test is carried out for 5,000 hours with a sunshine weatherometer (WEL-300 available from Suga Test Instruments Co., Ltd.) according to JIS B7753 while subjecting both surfaces of a sample to radiation with sun light.

Evaluation is made by observing an interface between the EVA and the coating film or the sheet and appearance with naked eyes.

### Criteria for evaluation of interface

○: No unusual condition is found.
△: Peeling, whitening and blistering are found.
X: Remarkable peeling, whitening and blistering exist.

### Criteria for evaluation of appearance

○: No unusual condition is found.
△: Peeling, whitening and blistering are found.
×: Remarkable peeling, whitening and blistering exist.

### EXAMPLE 5

A back sheet C2 of three-layer structure was prepared in the same manner as in Example 4 except that an aluminum sheet (sheet B, 0.5 mm) was used instead of the sheet A and the curable coating 2 was used instead of the curable coating 1, and adhesion 1 (between the coating film and the sheet) and bending characteristics thereof were evaluated in the same manner as in Example 4. The results are shown in Table 3.

Subsequently an EVA resin sheet was placed on one of the coated films of this back sheet C2 and a glass plate was further placed thereon, followed by the compression at 150°C at a pressure of 0.7 MPa, to produce a sample C2 (embodiment shown in Fig. 3) composed of EVA/cured coating film (black)/sheet B/cured coating film (black). Adhesion 2 (between the EVA and the coating film) and weatherability were evaluated using this EVA-adhered sample C2. The results are shown in Table 3.

### EXAMPLE 6

A silica-deposited PET film (sheet A) was used as a water-impermeable sheet, and the curable coating 3 prepared in Preparation Example 3 was coated on the both surfaces of this sheet A by air spray so as to give a dried coating film thickness of 20 µm in each surface, followed by drying at 180°C for ten minutes, to produce a back sheet C3 of three-layer structure.

Adhesion 1 (between the coating film and the sheet) and bending characteristics were evaluated using this back sheet C3. The results are shown in Table 3.

Subsequently an EVA resin sheet was placed on one of the coating films of this back sheet C3 and a glass plate was further placed thereon, followed by the compression at 150°C at a pressure of 0.7 MPa, to produce a sample C3 (embodiment shown in Fig. 3) composed of EVA/cured coating film (white)/sheet A/cured coating film (white). Adhesion 2 (between the EVA and the coating film) and weatherability were evaluated using this EVA-adhered sample C3. The results are shown in Table 3.

### EXAMPLE 7

A silica-deposited PET film (sheet A) was used as a water-impermeable sheet, and the curable coating 4 prepared in Preparation Example 4 was coated on the both surfaces of this sheet A by air spray so as to give a dried coating film thickness of 20 µm in each surface, followed by drying at 180°C for ten minutes, to produce a back sheet C4 of three-layer structure.

Adhesion 1 (between the coating film and the sheet) and bending characteristics were evaluated using this back sheet C4. The results are shown in Table 3.

Subsequently an EVA resin sheet was placed on one of the coating films of this back sheet C4 and a glass plate was further placed thereon, followed by the compression at 150°C at a pressure of 0.7 MPa, to produce a sample C4 (embodiment shown in Fig. 3) composed of EVA/cured coating film (white)/sheet A/cured coating film (white). Adhesion 2 (between the EVA and the coating film) and weatherability were evaluated using this EVA-adhered sample C4. The results are shown in Table 3.

### EXAMPLE 8

A silica-deposited PET film (sheet A) was used as a water-impermeable sheet, and the curable coating 1 prepared in Preparation Example 1 was coated on one surface of this sheet A by air spray so as to give a dried coating film thickness of 20 µm while the curable coating 5 prepared in Preparation Example 5 was coated on the other surface of the Sheet A by air spray so as to give a dried coating film thickness of 20 µm, followed by drying at 180°C for two minutes, to produce a back sheet C5 of three-layer structure.

Adhesion 1 (between the coating film of the curable coating 5 and the sheet) and bending characteristics were evaluated using this back sheet C5. The results are shown in Table 3.

Subsequently an EVA resin sheet was placed on one surface of the coating film of the curable coating 5 of this back sheet C5 and a glass plate was further placed thereon, followed by the compression at 150°C at a pressure of 0.7 MPa, to produce a sample C5 (embodiment shown in Fig. 3) composed of EVA/cured coating film (clear)/sheet A/cured coating film (black). Adhesion 2 (between the EVA and the coating film) and weatherability were evaluated using this EVA-adhered sample C5. The results are shown in Table 3.

**TABLE 3**

| Structure of Back Sheet (Fig. 3) | Ex. 4 | Ex. 5 | Ex. 6 | Ex. 7 | Ex. 8 |
|---|---|---|---|---|---|
| Coating film | Curable coating 1 | Curable coating 2 | Curable coating 3 | Curable coating 4 | Curable coating 5 |
| Water impermeable sheet | Sheet A | Sheet B | Sheet A | Sheet A | Sheet A |
| Coating film | Curable coating 1 | Curable coating 2 | Curable coating 3 | Curable coasting 4 | Curable coating 1 |
| Characteristics of back sheet | | | | | |
| Adhesion 1 (one-time) | 100/100 | 100/100 | 100/100 | 100/100 | 100/100 |
| Adhesion 1 (three-time) | 100/100 | 100/100 | 100/100 | 100/100 | 100/100 |
| Bending characteristics (number of test pieces) | 1 | 1 | 1 | 1 | 1 |
| EVA laminate (sample) | | | | | |
| EVA laminate surface | Coating film side | Coating film side | Coating film side | Coating film side | Coating film (Curable coating 5) side |
| Adhesion 2 | | | | | |
| Peeling strength (N/cm) | 26 | 35 | 29 | 29 | 29 |
| Weatherability | | | | | |
| Interface with EVA | ○ | ○ | ○ | ○ | ○ |
| Appearance | ○ | ○ | ○ | ○ | ○ |

From Table 3, it can be seen that by forming cured coating films on both surfaces, adhesion to both a water-impermeable sheet and an EVA is improved, and this adhesion is maintained even after a weatherability test.

### EXAMPLE 9

A polyester (PET) film (Lumilar available from TORAY INDUSTRIES, INC., containing a white pigment, thickness: 75 µm) was laminated on the sheet A side of the back sheet A1 of two-layer structure prepared in Example 1 by use of a polyester adhesive to prepare a back sheet D1 of three layer structure.

Adhesion 1 (between the sheet A and the PET film) and bending characteristics were evaluated using this back sheet D1. The results are shown in Table 4.

Subsequently an EVA resin sheet was placed on the coated film of the curable coating 1 of this back sheet D1 and a glass plate was further placed thereon, followed by the compression at 150°C at a pressure of 0.7 MPa, to produce a sample D1 (embodiment shown in Fig. 4) composed of EVA/cured coating film (black)/sheet A/adhesive/PET film. Adhesion 2 (between the EVA and the coating film) and anti-blocking property were evaluated using this EVA-adhered sample D1. The results are shown in Table 4.

### EXAMPLE 10

A silica-deposited PET film (sheet A) was used as a water-impermeable sheet, and the curable coating 7 prepared in Preparation Example 7 was coated on the both surfaces of this sheet A by air spray so as to give a dried coating film thickness of 20 µm in each surface, followed by drying at 180°C for two minutes, to produce a back sheet C6 of three-layer structure. Adhesion 1 (between the sheet A and the cured coating film) and bending characteristics were evaluated using this back sheet C6. The results are shown in Table 4.

Subsequently an EVA resin sheet was placed on one surface of the coating film of this back sheet C6 and a glass plate was further placed thereon, followed by the compression at 150°C at a pressure of 0.7 MPa, to produce a sample C6 (embodiment shown in Fig. 3) composed of EVA/cured coating film (black)/sheet A/cured coating film (black). Adhesion 2 (between the EVA and the coating film) and anti-blocking property were evaluated using this EVA-adhered sample C6. The results are shown in Table 4.

**TABLE 4**

| Structure of back sheet | Ex. 9 (Fig. 4) | Ex. 10 (Fig. 3) |
|---|---|---|
| Coating film or film | Curable coating 1 | Curable coating 7 |
| Water-impermeable sheet | Sheet A | Sheet A |
| Coating film or film | PET film | Curable coating 7 |
| Characteristics of back sheet | | |
| Adhesion 1 (one-time) | 100/100 | 100/100 |
| Adhesion 1 (three-time) | 100/100 | 100/100 |
| Bending characteristics (number of test pieces) | 1 | 1 |
| EVA laminate (sample) | | |
| EVA laminate surface | Coated film side | Coated film side |
| Adhesion 2 | | |
| Peeling strength (N/cm) | 26 | 27 |
| Anti-blocking property | Δ | ○ |

### EXAMPLE 11

An EVA resin sheet, a solar cell, an EVA resin sheet and a glass plate were placed in this order on the coating film surface of the back sheet A1 of two-layer structure prepared in Example 1, followed by the compression at 150°C at a pressure of 0.7 MPa in vacuo, to produce a solar cell module (embodiment shown in Fig. 1).

### EXAMPLE 12

An EVA resin sheet, a solar cell, an EVA resin sheet and a glass plate were placed in this order on the sheet A surface of the back sheet A1 of two-layer structure prepared in Example 1 on a polyester adhesive, followed by the compression at 150°C at a pressure of 0.7 MPa in vacuo, to produce a solar cell module (embodiment shown in Fig. 2).

### EXAMPLE 13

An EVA resin sheet, a solar cell, an EVA resin sheet and a glass plate were placed in this order on the coating film surface of the back sheet C 1 of three-layer structure prepared in Example 4, followed by the compression at 150°C at a pressure of 0.7 MPa in vacuo, to produce a solar cell module (embodiment shown in Fig. 3).

### EXAMPLE 14

An EVA resin sheet, a solar cell, an EVA resin sheet and a glass plate were placed in this order on the coating film surface of the back sheet D1 of three-layer structure prepared in Example 9, followed by the compression at 150°C at a pressure of 0.7 MPa in vacuo, to produce a solar cell module (embodiment shown in Fig. 4).

### EXAMPLE 15

An EVA resin sheet, a solar cell, an EVA resin sheet and a glass plate were placed in this order on the PET film surface of the back sheet D1 of three-layer structure prepared in Example 9, followed by the compression at 150°C at a pressure of 0.7 MPa in vacuo, to produce a solar cell module (embodiment shown in Fig. 5).

### Explanation of Symbols

- 1: Solar cell
- 2: Sealant layer
- 3: Surface layer
- 4: Back sheet
- 5: Water-impermeable sheet
- 6: Fluorine-containing cured coating film layer
- 7: Sheet or coating film
- 8: Resin sheet
- 9: Resin sheet

## Claims

1. A back sheet of a solar cell module having, on at least one surface of a water-impermeable sheet, a cured coating film layer of a coating comprising a hydroxyl-containing fluoropolymer and an isocyanate prepolymer and/or a melamine resin as a curing agent.

2. The back sheet of Claim 1 having, on both surfaces of the water-impermeable sheet, the cured coating film layers of the coating comprising the hydroxyl-containing fluoropolymer.

3. The back sheet of Claim 1 having, on one surface of the water-impermeable sheet, the cured coating film layer of the coating comprising the hydroxyl-containing fluoropolymer, and, on another surface thereof, a cured coating film layer of a coating comprising a fluoropolymer having no curable functional groups, a fluoropolymer sheet, a polyester sheet or a coating film of a polyester coating.

4. The back sheet of any of Claims 1 to 3, wherein the water-impermeable sheet is a Si- or silica-deposited polyester sheet or a metal sheet.

5. The back sheet of any of Claims 1 to 4, wherein the cured coating film layer of the coating comprising the hydroxyl-containing fluoropolymer is formed on the water-impermeable sheet at the side of a sealant layer of the solar cell module.

6. A solar cell module which is provided with the back sheet of any of Claims 1 to 5.

7. A solar cell module which comprises a laminated structure where a sealant layer comprising ethylene/vinyl acetate copolymer and a cured coating film layer of a coating comprising a hydraxyl-containing fluoropolymer and an isocyanate prepolymer and/or melamine resin as a curing agent are directly laminated.

8. A solar cell module which comprises a laminated structure where a sealant layer comprising ethylene/vinyl acetate copolymer and a water-impermeable sheet are laminated on a cured coating film layer of a coating comprising a hydroxyl-containing fluoropolymer and an isocyanate prepolymer and/or a melamine resin as a curing agent.

9. The solar cell module of Claim 8, wherein the cured coating film layer of the coating comprising the hydroxyl-containing fluoropolymer is formed on both surfaces of the water-impermeable sheet.

10. The solar cell module of Claim 8, wherein a cured coating film layer of a coating comprising a fluoropolymer having no curable functional groups, a fluoropolymer sheet, a polyester sheet or a coating film of a polyester coating is formed on the other surface of the water-impermeable sheet.
